# EUROPEAN PATENT SPECIFICATION

(11) **EP 3 662 580 B1**
(45) Date of publication and mention of the grant of the patent: **18.11.2026**
(21) Application number: 18750191.1
(22) Date of filing: 03.08.2018
(51) Int. Cl.: H03K 19/00

(54) **SLEW-LIMITED OUTPUT DRIVER CIRCUIT**
SLEW-BEGRENZTE AUSGANGSTREIBERSCHALTUNG
CIRCUIT D'ATTAQUE DE SORTIE À VITESSE DE BALAYAGE LIMITÉE

(30) Priority: 04.08.2017 DE 102017117778
(43) Date of publication of application: 10.06.2020
(73) Proprietor: Racyics GmbH, 01069 Dresden (DE)
(72) Inventor: HENKER, Stephan, 01683 Nossen (DE); DIETRICH, Monika, 01159 Dresden (DE)
(74) Representative: Lippert Stachow Patentanwälte Rechtsanwälte Partnerschaft mbB
(86) International application number: PCT/EP2018/071117
(87) International publication number: WO 2019/025586

(56) References cited:
- EP-A2- 0 735 687
- US-A- 5 581 197
- US-A- 5 654 663

## Description

The invention discloses a slew-limited output driver circuit.

With output drivers, fast rise times can cause electromagnetic emissions and noise. Furthermore, high output currents due to electro-migration reduce the life of said circuits. It is therefore desirable that an adequate limitation of the signal rise times would eliminate the disturbing effects. The signal rise times are related to the slew-rate which is defined as the change of voltage or current, or any other signal quantity, per unit of time.

In the prior art, various possibilities for limiting the rise time are known, which can be subdivided essentially into two groups: According to US 6,441,653, namely the limitation of the output current and according to US 7,471,111, namely the detection and adjustment of the voltage profile at the output pad of the driver.

US 6,586,980 B1 discloses a driver circuit having a slew rate control system that ensures the highly linear discharge of a capacitor used for said slew rate control of a power driving stage from a maximum voltage, such as ground, of the driver circuit.

The limitation of the output current possesses the following disadvantages: Resistors in the output path require high layout space for the resistive components, as a high current carrying capacity and thermal stability must be ensured. Furthermore, the signal level at the resistive load will be disturbed by the resulting resistive voltage divider between the driver and the current limiting. Also a dynamic change of the resistance value is difficult to manage.

If a current source as an output driver, as in US 7,471,111 or US 6,586,980 B1 is used no low-impedance driver will be feasible and the signal level at the resistive load will be disturbed as well.

Also the detection and adjustment of the voltage curve at the output pad of the driver according to the prior art has a few disadvantages. On the one hand, if the output driver is regulated based on the output level, for example if, like in US 6,441,653 the output current of the preamplifier is reduced in accordance with the output voltage, whereby the driver transistor is turned on slowly, it is detrimental that the recharge current of the preamplifier is partially dissipated. Furthermore, the output voltage shows a nonlinear characteristic due to the variable gate voltage of the output driver, and an ESD (electrostatic discharge) protection for the transistor gate of the feedback will be necessary. On the other hand, if a reference edge is used and its replication has to be generated at the output of the output driver a high circuitry complexity is necessary, the switching speed is limited and there is a high latency in the signal path.

It is therefore the purpose of the invention to find a circuitry that allows a flexible setting of the slew-rate of an integrated circuit, with only a small footprint and latency, and which allows realizing different driver modes without additional components integrated protection against ESD and short circuit.

The object of the invention will be solved by a slew-limited output driver circuit according to independent claim 1.

In a preferred embodiment of the inventive slew-limited output driver circuit, if the lead transistor (P2 or N2) of the first and/or second current mirror is switched as a diode, the output (PAD) functions as a current driver with high internal resistance. So, one or the other or both current mirrors (the first and the second current mirror) can be switched as a diode. If the lead transistor (P2 or N2) is switched as a diode, a constant gate voltage at the corresponding output transistor (P1 or N1) and thus a constant output current is generated, whereby a linear increase of the output voltage is achieved at a capacitive load. The output thus functions as a current driver with high internal resistance.

In another preferred embodiment of the inventive slew-limited output driver circuit, if the additional switch (P3 or N3) at the lead transistor (P2 or N2) of the first and/or second current mirror is open, the output (PAD) functions as a voltage source with low internal resistance. If the switch (P3 or N3) on the lead transistor (P2 or N2) is turned off, hence it is open, the gate-source voltage at the output transistor (P1 or N1) increases so that it opens completely and the output operates as a voltage source with low internal resistance.

In a further preferred embodiment of the inventive slew-limited output driver circuit, the control signals control a pull-up driver and a pull-down driver comprising pass transistors (P4, respectively N4) and the current mirror switch (P3, respectively N3). The pull-up driver is controlled by the control signals p_prectl, p_fbe and the pull-down driver is controlled by the control signals n_prectl, n_fbe.

It is preferred that the control signals are switched separately from each other. This has the effect that three different operation modes can be realized as described in the following.

According to the inventive slew-limited output driver circuit, if said control signals p_prectl and p_fbe are logic high (logic 1) and n_prectl and n_fbe are logic low (logic 0) the operating mode of the output driver is a voltage source mode, whereas a slew-rate of the slew-limited output driver circuit is not limited. Logic low or logic 0 means that the considered node is very low resistive or on ground level. Logic high or logic 1 means that the considered node is very low resistive or on supply voltage level. A tri-state means that the node is very high resistive. By adjusting the control signals in the described way above the operating mode of the slew-limited output driver circuit can be adjusted to a voltage source mode. In the voltage source mode the circuit has a low output impedance, a small rise/fall time and slew-rate is not limited.

Also according to the inventive slew-limited output driver circuit, if said control signals p_prectl and n_fbe are logic low (logic 0) and n_prectl and p_fbe are logic high (logic 1) the operating mode of the output driver is a current source mode, whereas the slew-rate of the slew-limited output driver is limited. In the current source mode the circuit has a high output impedance, constant output current, limited slew-rate and a linear change of output voltage on capacitive load.

And furthermore according to the inventive slew-limited output driver circuit, if said control signals p_prectl and n_prectl are in a tri-state Z, p_fbe is logic low (logic 0) and n_fbe is logic high (logic 1) the operating mode of the output driver is automatically switched into a voltage source mode or into a current source mode as soon as a change in the output current level is performed. In the so-called automatic mode, the turn-off of the conducting transistor (P1 or N1) is controlled by the output voltage via a pass transistor (P4 or N4). If the output level has not yet reached the target voltage, the circuit operates as a current driver with limited output current and high internal resistance, however, if the target voltage level is reached, the circuit is automatically switched to voltage source mode with low internal resistance.

Not part of the invention, but a specific aspect of the inventive slew-limited output driver circuit is, if there is a short circuit at the output (PAD) of the output driver circuit, the output driver circuit remains in the current source mode and provides a limited output current only.

Hence the inventive slew-limited output driver circuit provides an integrated short-circuit protection. If there is a short circuit at the output and the output level does not change, the driver remains in current source mode and provides only the limited set output current.

In a preferred embodiment of the inventive slew-limited output driver circuit, no transistor gates of the current mirror transistors and the additional switch are directly connected to the output (PAD). This has the advantage that since no transistor gates are connected directly to the output for the realization, there is no danger due to ESD events.

Not part of the invention, but a specific aspect of the slew-limited output driver circuit is that it provides a switchable pre-emphasis by pre-charging / discharging the switchable current mirror. This means, that it is possible to pre-emphasize the output signal (pre-emphasis) by pre-charging or discharging the nodes p_predrv or n_predrv before the switching operation in order to improve the signal properties on lines with low-pass behavior. For this purpose, the current mirror is constructed as a high-swing cascode, which is switched at the cascode voltage. If the gate has been discharged before switching on, the output current starting from 0 will slowly increase to the set current limit (soft start); however, when the gate is charged, the output current rises rapidly to a value greater than the set current limit and then drops to the limit (this is called pre-emphasis).

The invention can be summarized by the following advantages over the prior art: Firstly, a constant output current during the switching phase of the output signal of the slew-limited output driver can be realized; secondly, the inventive circuit provides an integrated short-circuit protection; thirdly, there are different current limiting modes: a) switched off (voltage source mode), b) only active when changing level (automatic mode), c) permanently active (constant current source mode); fourthly, the inventive circuit provides a switchable pre-emphasis by pre-charging / discharging the current mirror; fifthly, only low chip area is necessary due to few additional elements; and sixthly, the feedback is inherently protected against ESD.

The invention will be explained in more detail using an exemplary embodiment.

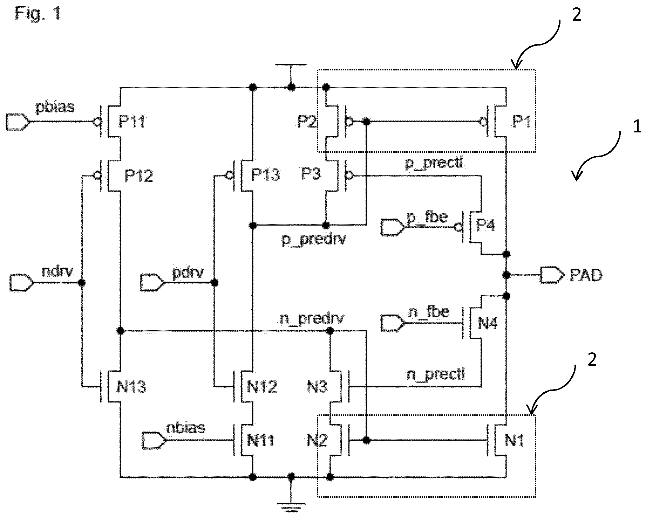

The appended drawing shows
- Fig. 1: Inventive slew-limited output driver circuit.

The figure shows the inventive slew-limited output driver circuit. The inventive circuit uses in its core a current mirror (P1, P2 or N1, N2), by means of an additional switch (P3 or N3) in response to control signals (prectl, fbe) and / or the current level at the output (PAD) is switched. The control signals exist respectively for the pull-up driver (p_prectl, p_fbe) and the pull-down driver (n_prectl, n_fbe). They can be switched separately in a general embodiment.

If the lead transistor (P2 or N2) is switched as a diode, a constant gate voltage at the corresponding output transistor (P1 or N1) and thus a constant output current is generated, whereby a linear increase of the output voltage is achieved at a capacitive load. The output thus functions as a current driver with high internal resistance.

If the switch (P3 or N3) on the lead transistor (P2 or N2) is turned off, hence it is open, the gate-source voltage at the output transistor (P1 or N1) increases so that it opens completely and the output operates as a voltage source with low internal resistance.

By the control signals (prectl, fbe), the operating mode, the voltage source mode or the current source mode is set as shown in the following tables:

| **p_prectl** | **p_fbe** | **function** |
|---|---|---|
| logic 1 (low resistive, supply voltage) | logic 1 (low resistive, supply voltage) | voltage source mode slew-rate not limited |
| logic 0 (low resistive, ground) | logic 1 (low resistive, supply voltage) | current source mode slew-rate limited |
| Tri-state Z (high resistive) | logic 0 (low resistive, ground) | voltage source mode, current source mode/slew-rate limitation will be automatically activated, if there is a level change at the output |
| else | | Not allowed |

| **n_prectl** | **n_fbe** | **function** |
|---|---|---|
| logic 0 | logic 0 | voltage source mode |
| (low resistive, ground) | (low resistive, ground) | slew-rate not limited |
| logic 1 (low resistive, supply voltage) | logic 0 (low resistive, ground) | current source mode slew-rate limited |
| Tri-state Z (high resistive) | logic 1 (low resistive, supply voltage) | voltage source mode, current source mode/slew-rate limitation will be automatically activated, if there is a level change at the output |
| else | | Not allowed |

In the so-called automatic mode, the turn-off of the conducting transistor (P1 or N1) is controlled by the output voltage via a pass transistor (P4 or N4). If the output level has not yet reached the target voltage, the circuit operates as a current driver with limited output current and high internal resistance, however, if the target voltage level is reached, the circuit is automatically switched to voltage source mode with low internal resistance.

If there is a short circuit at the output and the output level does not change, the driver remains in current source mode and provides only the limited set output current.

Since no transistor gates are connected directly to the output for the realization, there is no danger due to ESD events.

In addition, it is possible to pre-emphasize the output signal (pre-emphasis) by pre-charging or discharging the nodes p_predrv or n_predrv before the switching operation in order to improve the signal properties on lines with low-pass behavior. For this purpose, the current mirror is constructed as a high-swing cascode, which is switched at the cascode voltage. If the gate has been discharged before switching on, the output current starting from 0 will slowly increase to the set current limit (soft start); however, when the gate is charged, the output current rises rapidly to a value greater than the set current limit and then drops to the limit (this is called pre-emphasis).

The essential advantage of the claimed invention is the usage of a switchable current mirror, the control of the current mirror by direct feedback of the output, and the implementation of adjustable operating modes, such as current source mode / voltage source mode / automatically switchable mode.

### List of Reference Signs

1 Slew-limited output driver circuit
2 switchable current mirror
P1+P2 first current mirror
N1+N2 second current mirror
P1, N1 output transistor
P2, N2 lead transistor
P3, N3 additional switch
P4 pull-up driver
N4 pull-down driver
x_prectl, x_fbe control signal, with x = p, n
PAD output with output signal

## Claims

1. Slew-limited output driver circuit (1) comprising two switchable current mirrors (2) (P1,P2 and N1, N2) providing an output current equal to an input current, wherein the current mirrors (P1, P2, and N1, N2) are controlled by means of an additional switch (P3, respectively N3), which is switched in response to control signals (prectl, fbe) and/or an output current level (PAD) of the output of the output driver circuit, whereas different operating modes of the slew-limited output driver are realized by the control signals, wherein if said control signals p_prectl and p_fbe are high and n_prectl and n_fbe are low the operating mode of the output driver is a voltage source mode, whereas a slew-rate of the slew-limited driver is not limited, wherein if said control signals p_prectl and n_fbe are low and n_prectl and p_fbe are high the operating mode of the output driver is a current source mode, whereas the slew-rate of the slew-limited driver is limited, wherein if said control signals p_prectl and n_prectl are in a tri-state Z, p_fbe is low and n_fbe is high the operating mode of the output driver is automatically switched into a voltage source mode or into a current source mode, if a change in the output current level is performed, whereas the control signals are inputted to a gate node of the additional switches (P3, N3) and a pull-up (P4) and a pull-down driver (N4) respectively.

2. Slew-limited output driver circuit (1) according to claim 1, wherein the switchable current mirror (2) (P1, P2, respectively N1, N2) comprises a first current mirror (P1, P2) and a second current mirror (N1, N2), whereas each current mirror comprises a lead transistor (P2 or N2) and an output transistor (P1 or N1).

3. Slew-limited output driver circuit (1) according to claims 1 or 2, wherein if the lead transistor (P2 or N2) of the first and/or second current mirror is switched as a diode, the output (PAD) functions as a current driver with high internal resistance.

4. Slew-limited output driver circuit (1) according to claims 1 or 2, wherein if the additional switch (P3 or N3) at the lead transistor (P2 or N2) of the first and/or second current mirror is open, the output (PAD) functions as a voltage source with low internal resistance.

5. Slew-limited output driver circuit according to claim 1, wherein the control signals control a pull-up driver and a pull-down driver comprising pass transistors P4, respectively N4 and the current mirror switch (P3, respectively N3).

6. Slew-limited output driver circuit (1) according to claim 5, wherein the control signals are switched separately from each other.

7. Slew-limited output driver circuit (1) according to one of the former claims, wherein no transistor gates of the current mirror transistors and the additional switch are directly connected to the output (PAD).

## Patentansprüche

1. Anstiegsgeschwindigkeitsbegrenzte Ausgangstreiberschaltung (1), umfassend zwei schaltbare Stromspiegel (2) (P1, P2 und N1, N2), die einen Ausgangsstrom bereitstellen, der gleich einem Eingangsstrom ist, wobei die Stromspiegel (P1, P2 und N1, N2) mittels eines zusätzlichen Schalters (P3 beziehungsweise N3) gesteuert werden, der als Reaktion auf Steuersignale (prectl, fbe) und/oder einen Ausgangsstrompegel (PAD) des Ausgangs der Ausgangstreiberschaltung geschaltet wird, während unterschiedliche Betriebsmodi des anstiegsgeschwindigkeitsbegrenzten Ausgangstreibers durch die Steuersignale realisiert werden, wobei, falls die Steuersignale p_prectl und p_fbe hoch sind und n_prectl und n_fbe niedrig sind, der Betriebsmodus des Ausgangstreibers ein Spannungsquellenmodus ist, während eine Anstiegsgeschwindigkeit des anstiegsgeschwindigkeitsbegrenzten Treibers nicht begrenzt ist, wobei, falls die Steuersignale p_prectl und n_fbe niedrig sind und n_prectl und p_fbe hoch sind, der Betriebsmodus des Ausgangstreibers ein Stromquellenmodus ist, während die Anstiegsgeschwindigkeit des anstiegsgeschwindigkeitsbegrenzten Treibers begrenzt ist, wobei, falls die Steuersignale p_prectl und n_prectl in einem Tri-State Z sind, p_fbe niedrig ist und n_fbe hoch ist, der Betriebsmodus des Ausgangstreibers automatisch in einen Spannungsquellenmodus oder in einen Stromquellenmodus geschaltet wird, falls eine Änderung des Ausgangsstrompegels durchgeführt wird, während die Steuersignale in einen Gate-Knoten der zusätzlichen Schalter (P3, N3) und eines Pull-up- (P4) beziehungsweise eines Pull-down-Treibers (N4) eingegeben werden.

2. Anstiegsgeschwindigkeitsbegrenzte Ausgangstreiberschaltung (1) nach Anspruch 1, wobei der schaltbare Stromspiegel (2) (P1, P2 beziehungsweise N1, N2) einen ersten Stromspiegel (P1, P2) und einen zweiten Stromspiegel (N1, N2) umfasst, während jeder Stromspiegel einen Leittransistor (P2 oder N2) und einen Ausgangstransistor (P1 oder N1) umfasst.

3. Anstiegsgeschwindigkeitsbegrenzte Ausgangstreiberschaltung (1) nach Anspruch 1 oder 2, wobei, falls der Leittransistor (P2 oder N2) des ersten und/oder des zweiten Stromspiegels als eine Diode geschaltet ist, der Ausgang (PAD) als ein Stromtreiber mit hohem Innenwiderstand fungiert.

4. Anstiegsgeschwindigkeitsbegrenzte Ausgangstreiberschaltung (1) nach Anspruch 1 oder 2, wobei, falls der zusätzliche Schalter (P3 oder N3) an dem Leittransistor (P2 oder N2) des ersten und/oder des zweiten Stromspiegels geöffnet ist, der Ausgang (PAD) als eine Spannungsquelle mit niedrigem Innenwiderstand fungiert.

5. Anstiegsgeschwindigkeitsbegrenzte Ausgangstreiberschaltung nach Anspruch 1, wobei die Steuersignale einen Pull-up-Treiber und einen Pull-down-Treiber steuern, umfassend Durchgangstransistoren P4 beziehungsweise N4 und den Stromspiegelschalter (P3 beziehungsweise N3).

6. Anstiegsgeschwindigkeitsbegrenzte Ausgangstreiberschaltung (1) nach Anspruch 5, wobei die Steuersignale getrennt voneinander geschaltet werden.

7. Anstiegsgeschwindigkeitsbegrenzte Ausgangstreiberschaltung(1) nach einem der vorstehenden Ansprüche, wobei keine Transistor-Gates der Stromspiegeltransistoren und des zusätzlichen Schalters mit dem Ausgang (PAD) direkt verbunden sind.

## Revendications

1. Circuit d'attaque de sortie à vitesse de balayage limitée (1) comprenant deux miroirs de courant commutables (2) (P1, P2 et N1, N2) fournissant un courant de sortie égal à un courant d'entrée, dans lequel les miroirs de courant (P1, P2, et N1, N2) sont commandés au moyen d'un commutateur supplémentaire (P3, respectivement N3), qui est commuté en réponse à des signaux de commande (prectl, fbe) et/ou à un niveau de courant de sortie (PAD) de la sortie du circuit d'attaque de sortie, tandis que différents modes de fonctionnement du circuit d'attaque de sortie à vitesse de balayage limitée sont réalisés par les signaux de commande, dans lequel si lesdits signaux de commande p_prectl et p_fbe sont à l'état haut et n_prectl et n_fbe sont à l'état bas le mode de fonctionnement du circuit d'attaque de sortie est un mode source de tension, tandis qu'une vitesse de balayage du circuit d'attaque à vitesse de balayage limitée n'est pas limitée, dans lequel si lesdits signaux de commande p_prectl et n_fbe sont à l'état bas et n_prectl et p_fbe sont à l'état haut le mode de fonctionnement du circuit d'attaque de sortie est un mode source de courant, tandis que la vitesse de balayage du circuit d'attaque à vitesse de balayage limitée est limitée, dans lequel si lesdits signaux de commande p_prectl et n_prectl sont dans un état à trois états Z, p_fbe est à l'état bas et n_fbe est à l'état haut le mode de fonctionnement du circuit d'attaque de sortie est automatiquement commuté dans un mode source de tension ou dans un mode source de courant, si un changement du niveau de courant de sortie est effectué, tandis que les signaux de commande sont entrés sur un nœud de grille des commutateurs supplémentaires (P3, N3) et d'un circuit d'attaque d'excursion haute (P4) et d'excursion basse (N4) respectivement.

2. Circuit d'attaque de sortie à limitation de vitesse de balayage (1) selon la revendication 1, dans lequel le miroir de courant commutable (2) (P1, P2, respectivement N1, N2) comprend un premier miroir de courant (P1, P2) et un second miroir de courant (N1, N2), tandis que chaque miroir de courant comprend un transistor de tête (P2 ou N2) et un transistor de sortie (P1 ou N1).

3. Circuit d'attaque de sortie à limitation de vitesse de balayage (1) selon la revendication 1 ou 2, dans lequel si le transistor de tête (P2 ou N2) du premier et/ou du second miroir de courant est commuté en diode, la sortie (PAD) fonctionne comme un circuit d'attaque de courant à résistance interne élevée.

4. Circuit d'attaque de sortie à vitesse de balayage limitée (1) selon la revendication 1 ou 2, dans lequel si le commutateur supplémentaire (P3 ou N3) au niveau du transistor de tête (P2 ou N2) du premier et/ou du second miroir de courant est ouvert, la sortie (PAD) fonctionne comme une source de tension à faible résistance interne.

5. Circuit d'attaque de sortie à vitesse de balayage limitée selon la revendication 1, dans lequel les signaux de commande commandent un circuit d'attaque d'excursion haute et un circuit d'attaque d'excursion basse comprenant des transistors de passage P4, respectivement N4 et le commutateur de miroir de courant (P3, respectivement N3).

6. Circuit d'attaque de sortie à vitesse de balayage limitée (1) selon la revendication 5, dans lequel les signaux de commande sont commutés séparément les uns des autres.

7. Circuit d'attaque de sortie à vitesse de balayage limitée (1) selon l'une des revendications précédentes, dans lequel aucune grille de transistor des transistors de miroir de courant et du commutateur supplémentaire n'est directement connectée à la sortie (PAD).
